# EUROPEAN PATENT APPLICATION

(11) **EP 0 849 791 A1**
(43) Date of publication of application: **24.06.1998**
(21) Application number: 97122693.1
(22) Date of filing: 22.12.1997
(51) Int. Cl.: H01L 21/8249, H01L 21/8222

(54) **Improvements in or relating to electronic devices**

(30) Priority: 20.12.1996 US 33771 P
(71) Applicant: Texas Instruments Incorporated, Dallas, Texas 75251 (US)
(72) Inventor: Rost, Timothy A., Plano, TX 75023 (US); Giolma, William H., Dallas, TX 75287 (US); Montgomery, Clinton L., Coppell, TX 75019 (US)
(74) Representative: Schwepfinger, Karl-Heinz, Dipl.-Ing.

(57) **Abstract**

A method for fabricating a bipolar transistor includes the steps of forming a collector region (27, 39) having a first conductivity type and forming an emitter region (75) having a first conductivity type. The method further includes forming a base region (64) having a second conductivity, the base region contacting the emitter region (75) and also contacting the collector region (27, 39). The method additionally includes the step of subjecting the base (64) and emitter (75) regions to an oxidation step after formation of both the base and emitter regions.

## Description

### TECHNICAL FIELD OF THE INVENTION

This invention relates generally to the field of electronic devices, and more particularly, to a method for enhancing the reliability and performance of a bipolar transistor.

### BACKGROUND OF THE INVENTION

One concern for the reliability of bipolar transistors is current gain degradation that may result from the reverse bias of the emitter-base junction. As the scale of devices become smaller, the resulting electric fields within the devices further contribute to the degradation problem. For example, large electric fields may contribute to the generation of hot carriers, which may contribute to current gain degradation. The degradation of current gain may occur both in devices in which bipolar transistors interface with CMOS transistors and in devices comprising only bipolar transistors. The current gain degradation affects the switching speed of the bipolar transistors. Additionally, current gain degradation limits the bias voltages at which bipolar transistors may be operated. Greater bias voltages allow faster and more complicated circuits. Therefore, it is desirable to reduce the current gain degradation that occurs in bipolar transistors. One previous attempt at reducing current gain degradation in a bipolar transistor utilizes a low-dose arsenic implant in the base region in order to reduce the effects of hot carriers by reducing the electric field at the emitter-base junction.

### SUMMARY OF THE INVENTION

Therefore, a need has arisen for a new method that addresses the disadvantages and deficiencies of the prior art. Accordingly the present invention provides a method for fabricating a bipolar transistor that includes the steps of forming a collector region of a first conductivity type and an emitter region of a first conductivity type. The method further includes forming a base region of a second conductivity, the base region contacting the emitter region and the collector region. The method additionally includes subjecting the base and emitter regions to an oxidation step after formation of both the base and emitter regions.

The invention also provides a method for forming a BiCMOS transistor includes the steps of forming a CMOS transistor on the surface of a substrate and forming a bipolar transistor on the surface of the substrate. The step of forming a bipolar transistor includes the steps of forming a collector region and an emitter region of a first conductivity type, and forming a base region of a second conductivity type. The base region contacts the emitter region and the collector region. The method further includes subjecting the base and emitter regions to an oxidation step after formation of both the base and emitter regions.

The invention provides several technical advantages. For example, a bipolar transistor may be formed with enhanced reliability and performance. Bipolar transistors may have increased useful life due to the reduction of current gain degradation that may occur due to the reverse bias of the emitter-base junction and the generation of hot carriers. In addition, due to this reduction in current gain degradation, bipolar devices may operate at higher bias voltages. Maximum bias voltages are often a design constraint in bipolar devices; therefore it is desirable to increase the maximum bias voltage available to the designer. Additionally, greater bias voltages allow faster and more complicated circuits.

### BRIEF DESCRIPTION OF THE DRAWINGS

The present invention will now be further described by way of example, with reference to the accompanying drawings in which:
FIGURES 1 through 15 are cross-sectional views of a BiCMOS semiconductor structure in various states of fabrication, according to an embodiment of the method of the invention; and
FIGURE 16 is a graph showing reliability enhancement of a device fabricated according to the invention.

### DETAILED DESCRIPTION OF THE INVENTION

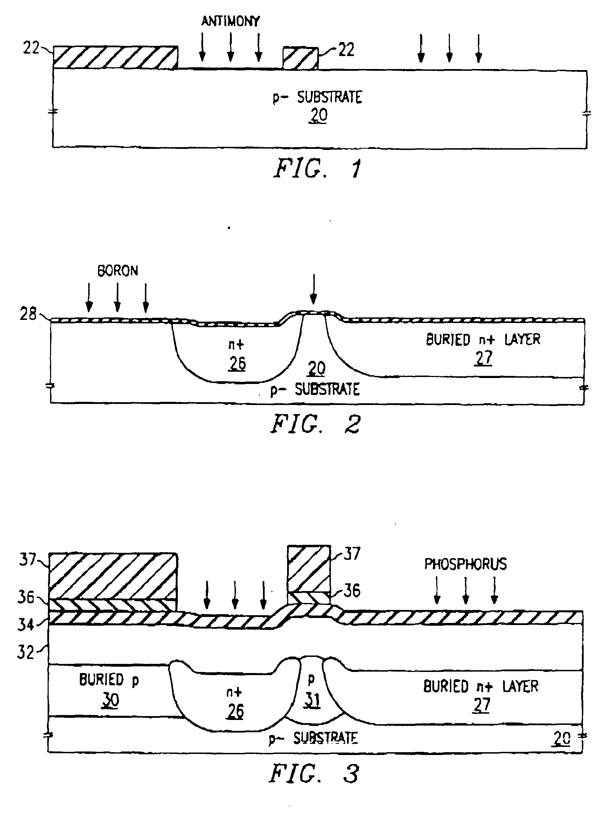

Like numerals are used for like and corresponding parts of the various drawings. The method described includes processing steps for formation of a bipolar transistor having increased performance and reliability due to a reduction of the impact on current gain degradation due to hot carrier effects. FIGURES 1 through 16 illustrate an embodiment and are cross-sectional views of a BiCMOS semiconductor structure in various states of fabrication. However, bipolar transistors alone, or in other combinations besides BiCMOS devices may be formed according to the teaching herein. One method of fabricating a BiCMOS semiconductor structure is described in U.S. Patent No. 5,124,271 to Havemann, entitled *Process for Fabricating a BiCMOS Integrated Circuit,* and assigned to Texas Instruments Incorporated.

FIGURE 1 is a cross-sectional view of a lightly doped p-type single crystal silicon substrate 20 in wafer form, shown prior to the formation of a buried n-type layer. A masking layer comprising, for example, an oxide layer 22, is formed, patterned, and etched according to any of a number of well-known techniques. Layer 22 is patterned as shown in FIGURE 1, and serves as a mask for the implant of buried n + regions 26 and 27, shown in FIGURE 2. Such an implant is indicated by the arrows of FIGURE 1. An example of an implant for forming the buried n + regions 26 and 27 in this embodiment is an antimony implant.

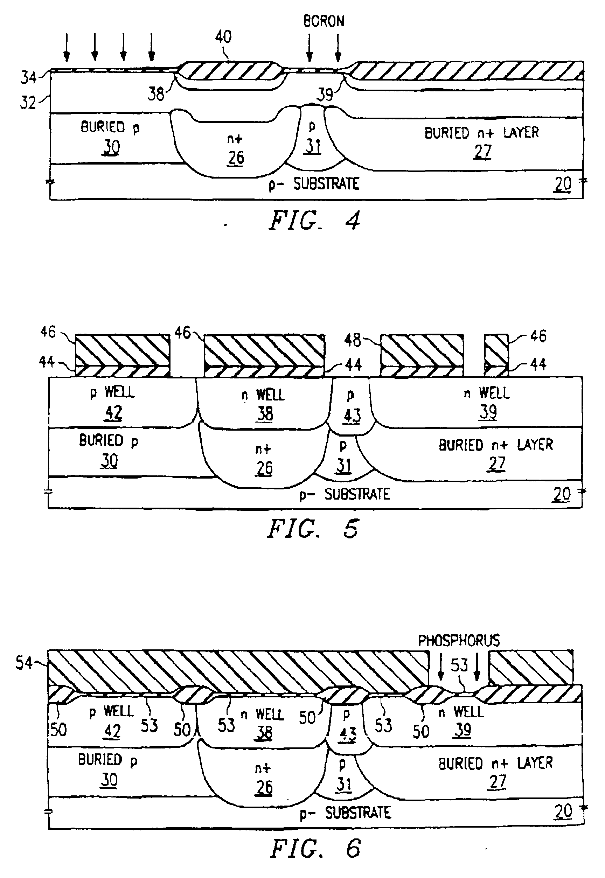

Referring now to FIGURE 2, the diffusion of the antimony to form buried n + regions 26 and 27 is shown. Buried n + region 27 will serve as a buried collector in a resulting bipolar transistor having increased reliability and performance. Oxide layer 22 is then stripped and a thin layer of pad oxide 28 is regrown. Pad oxide layer 28 protects the silicon surface from damage due to implantation or contamination. Buried p-type regions 30 and 31, shown in FIGURE 3, are then implanted through the pad oxide layer 28 with an appropriate p-type implant such as, for example, boron. Implantation of buried p-type region 30 and 31 may occur without a mask because n + regions 26 and 27 are heavily doped and can accommodate the counter-doping.

As shown in FIGURE 3, after implantation of buried p-type regions 30 and 31, pad oxide layer 28 is stripped and an epitaxial layer 32 of silicon is grown. A thin layer of oxide 34 is then grown on the surface of epitaxial layer 32, followed by deposition of a nitride layer 36. Nitride layer 36 may then be patterned and etched according to conventional techniques using, for example, photoresist layer 37, as shown in FIGURE 3. Nitride layer 36 serves as a mask for an n-well implant. Appropriate n-type ions, such as phosphorus ions, may then be implanted to form n-wells 38 and 39 in epitaxial layer 32. N-wells 38 and 39 are shown in FIGURE 4.

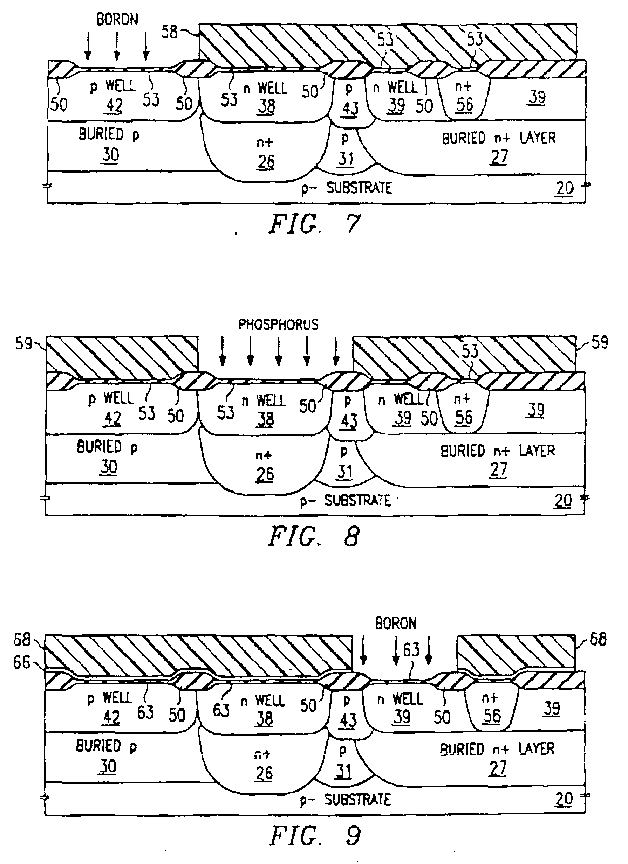

As shown in FIGURE 4, the n-well implant is then followed by an oxide growth step, resulting in thick oxide regions 40 overlying the regions receiving the n-well implant. Thick oxide regions 40 will serve as a mask over n-wells 38 and 39 for implantation of p-wells 42 and 43, shown in FIGURE 5. P-wells 42 and 43 are then implanted, masked by oxide regions 40 overlying n-well regions 38 and 39. The p-well implant may be, for example, a boron implant; however, other suitable implants may be used.

Referring now to FIGURE 5, following the p-well implant, both the n-well and p-well implants are driven to the desired depth. Oxide region 40 and such oxide as is formed in the drive step are then stripped. After the oxide regions 40 are etched, a layer 44 of oxide is grown, upon which nitride layer 46 is then deposited. Nitride layer 46 and oxide layer 44 are then patterned and etched to expose the isolation regions. An oxidation step is then performed to form recessed isolation oxide regions 50 between p-well regions 42 and 43 and n-well regions 38 and 39 respectively. Isolation oxide regions 50 are shown in FIGURE 6. The oxidation is masked by nitride layer 46 over the active regions of the structure. Any number of known techniques for forming field oxide regions may be used to form oxide regions 50, such as those discussed in U.S. Patent No. 5,124,271, assigned to Texas Instruments Incorporated.

The MOS transistors of the resulting BiCMOS device will be formed in and overlying p-well 42 and n-well 38. An NMOS transistor will be formed in and overlying p-well 42 and a PMOS transistor will be formed in and overlying n-well 38. A bipolar transistor having enhanced reliability and performance will be formed in and overlying n-well 39 and buried n + layer 27, with buried n + layer 27 and n-well 39 serving as the collector of the bipolar transistor having enhanced reliability and performance.

Referring now to FIGURE 6, the resultant recessed isolation oxide regions 50 are illustrated. With reference to FIGURE 6, additional processing steps associated with forming a deep collector contact for a bipolar transistor with enhanced reliability and performance are described. Nitride layer 46 and oxide layer 44 are stripped according to conventional techniques, clearing the surface of the wafer. A thin pregate oxide, or dummy gate oxide layer 53 is then grown for protection of the silicon surface during subsequent process steps. An alternative to such junction isolation between wells is the use of trench isolation. A masking layer 54, such as photoresist, is then patterned, as shown in FIGURE 6, to expose an area of n-well region 39 in which a bipolar transistor will be formed. An n-type implant, such as phosphorus, is implanted into n-well 39 to form a deep collector contact 56 extending from the surface of n-well region 38 to buried n + region 27, as shown in FIGURE 7.

Referring now to FIGURE 7, additional processing steps associated with forming an NMOS transistor in and overlying p-well 42 are described. A threshold voltage adjust ion implant may be performed to adjust the threshold voltages of the PMOS transistors according to the desired circuit operation. Mask layer 54 is stripped and mask layer 58 is formed. Mask layer 58, which may be photoresist, may be patterned using conventional photolithographic techniques and is used for implantation of p-type ions into p-well 42 to set n-channel threshold voltages.

As shown in FIGURE 8, additional processing steps associated with forming a PMOS transistor in and overlying n-well 38 are described. Phosphorus ions may then be implanted into n-well 38 to set p-channel threshold voltages. This step may utilize mask layer 59, which may be photoresist patterned according to conventional photolithographic techniques.

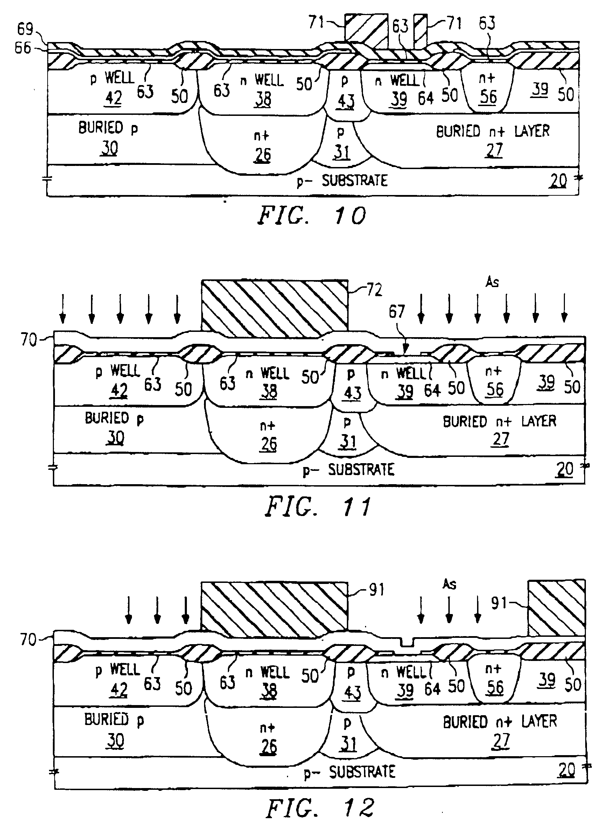

Referring to FIGURE 9, processing steps associated with forming a base of a bipolar transistor with enhanced reliability and performance are described. Oxide layer 59 is stripped and a thin layer of oxide 63 is regrown. Overlying thin oxide layer 63, a layer of polysilicon 66 is deposited. A mask layer 68, which may comprise photoresist, is then patterned and polysilicon layer 66 is etched to expose a region where the base of the bipolar transistor will be implanted. N-well 39 is then implanted through oxide layer 63 with, for example, boron ions to form base region 64, illustrated in FIGURE 10.

Referring now to FIGURE 10, additional processing steps associated with forming the emitter of a bipolar transistor with enhanced performance and reliability are described. An oxidation step may then be applied to the base 64 to anneal any implant damage and move the emitter-base electrical junction slightly below the silicon surface. Such oxidation may occur, for example, at 800° C; however, other suitable temperatures may be used. A nitride layer 69 may then be deposited overlying polysilicon layer 66 to serve as a hard mask for a subsequent emitter etch. Referring still to FIGURE 10, a layer of photoresist 71 is shown disposed above the surface of the wafer, patterned to define the location of the emitter for the bipolar transistor. Oxide layer 63 and nitride layer 69 above selected portions of base region 64 are then etched to expose the location 67, shown in FIGURE 11, of the incipient emitter contact to base region 64.

Referring now to FIGURE 11, processing steps associated with forming the gates of the NMOS and PMOS transistor and further processing steps associated with forming an emitter for a bipolar transistor with enhanced performance and reliability are described. After exposing the incipient emitter contact, photoresist 71, and nitride layer 69 are stripped, and a layer of polysilicon 70 is deposited over the surface of the wafer, contacting base region 64 in the incipient emitter contact area. Polysilicon layer 70 will serve as the gate electrode for the MOS transistors, and as an interconnect level, if desired. Polysilicon layer 70 will also serve as the source of the dopant for diffusion into the incipient emitter region in base 64 of the bipolar transistor, as described below. Polysilicon layer 70 is additive to polysilicon layer 66 at locations not in the incipient emitter contact, resulting in thicker polysilicon at those locations. Polysilicon layer 70 is then doped by way of an n + implant. The implant may be, for example, an arsenic implant, as indicated by the arrows in FIGURE 11. Implantation of polysilicon layer 70 at selected locations may be accomplished, as shown in FIGURE 11 by first masking the polysilicon layer 70 overlying n-well 38 with a masking layer 72, such as a photoresist layer, and implanting the exposed portions of polysilicon layer 70 with arsenic. This implantation step increases the conductivity of polysilicon layer 70.

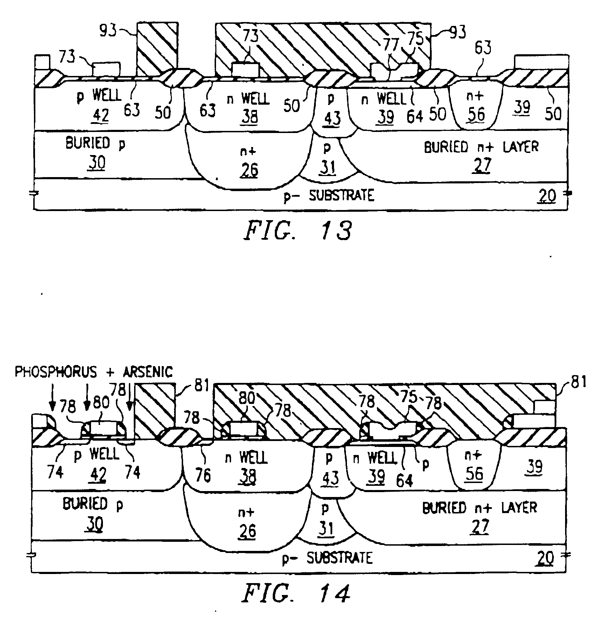

Referring now to FIGURE 12, the formation of the gates of the MOS transistors and the emitter of the bipolar transistor with enhanced performance and reliability is described. An additional masking layer 91 is then used for the emitter implant An anneal may then be performed to give the dopant enough mobility to diffuse dopant into the silicon to form the emitter-base junction, designated by reference numeral 77 in FIGURE 13.

Referring to FIGURE 13, additional processing steps associated with the formation of the gates of the MOS transistors and the emitter of the bipolar transistor with enhanced performance and reliability is described. Polysilicon layer 70 is shown after being patterned and etched for the formation of the gate electrodes 73 for the MOS transistors and the polysilicon emitter 75 of the bipolar transistor. Photoresist layer or masking layer 93 is patterned to define the source and drain regions 74 for the n-channel MOS transistor and for defining the n-well contact 76 implanted by a phosphorus and arsenic reach-through implant, as shown in FIGURE 14. The reach-through implant is intended to form the shallow and relatively lightly-doped n-type diffusion in the formation of an n-channel MOS transistor having a "lightly-doped-drain" (or graded junction) as described in U.S. Pat. No. 4,566,175 issued Jan. 28, 1987 and assigned to Texas Instruments Incorporated.

At this point, an oxidation step may be performed for the purpose of reducing current gain degradation that may occur due to the reverse bias of the emitter-base junction 77 and the generation of hot carriers. Such an oxidation step increases the useful life of the resulting bipolar transistor. In addition, due to this reduction in current gain degradation, bipolar devices incorporating such an oxidation step may operate at higher bias voltages. Maximum bias voltages are often a design constraint in bipolar devices; therefore it is desirable to increase the maximum bias voltage available to the designer. Additionally, greater bias voltages allow faster and more complicated circuits. The believed reason for the reduction in current gain degradation is the reduction of the boron surface concentration caused by out-diffusion of boron during the oxidation process, which leads to lower reverse emitter-base current.

The oxidation step may be a high temperature oxidation, such as oxidation at a temperature above 500°C for a period in the range of 10 to 200 minutes; however, it should be noted that any other appropriate oxidation technique is contemplated it is further contemplated that oxide will not necessarily best be formed on the base 64 and emitter 75 during the oxidation step, although oxide could be formed on the base 64 and emitter 75. According to another embodiment, the oxidation step may include placing the base 64 and emitter 75 in a nitrogen environment and then ramping the temperature of the nitrogen environment from approximately 775°C to approximately 850°C. The oxidation step further may include stabilizing the temperature of the nitrogen for approximately 10 minutes at approximately 850°C after ramping the temperature of the first nitrogen environment and then placing the base 64 and emitter 75 in an oxygen environment for approximately 60 minutes at approximately 850°C . At this point, the oxidation step may further include annealing the base 64 and emitter 75 in a nitrogen environment at approximately 850°C for approximately 20 minutes and then ramping the temperature of the nitrogen environment from 850°C to 775°C. Although particular temperatures, durations, and environments are described, other alternative oxidation processes may be used to reduce current gain degradation.

Although this oxidation process may be performed any time after formation of the base 64 and emitter 75, in one embodiment the oxidation process is performed before implantation of the sources and drains of the MOS transistors to avoid adversely affecting the diffusion of dopants in the source and drain regions. In addition, for formation of bipolar transistors outside the BiCMOS context, the oxidation process may be performed any time after formation of the base and emitter. However, performing such a process before formation of any insulating layer that may be formed overlying a portion of the emitter may be particularly advantageous because such an insulating layer may reduce the effect on the formation of hot carriers by the oxidation process.

FIGURE 14 illustrates the formation of sidewall nitride filaments 78 on each side of gate electrodes 80 and polysilicon emitter 75. Such formation is accomplished by stripping photoresist layer 93, depositing a conformal layer of TEOS oxide over the wafer, and then anisotropically etching the oxide layer leaving the sidewall filaments 78 shown in FIGURE 14. Oxide layer 63 is also removed by the same etch. Photoresist 81 is then patterned to again expose the n-channel source and drain regions 74, n-well contact 76, and collector contact 56. The source/drain implant is then performed, forming the deeper junction depth for the heavily doped source and drain of the n-channel MOS transistor; an example of such a source/drain implant is indicated by the arrows in FIGURE 14.

FIGURE 15 illustrates the formed source and drain regions 74 of the n - channel MOS transistor in p-well 42, as well as the n + contact 76 in n-well 38. Photoresist 81 is stripped, and a photoresist or masking pattern 82 is formed to define the source/drain regions 84 for the p channel MOS transistor in n-well 38. Additional processing steps may include, for example, forming interconnects (not shown) as described in U.S. Patent No. 5,124,271, assigned to Texas Instruments Incorporated.

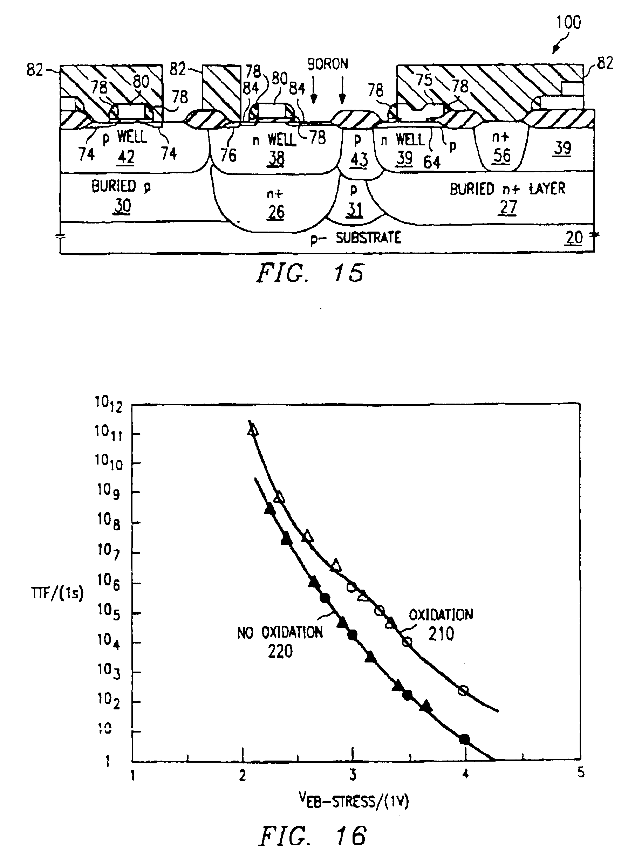

Test data of such BiCMOS devices is tabulated below and is also illustrated in FIGURE 16. The table illustrates performance enhancements over prior art BICMOS devices. The below table provides current gain (hFE) and breakdown voltage for the emitter-base junction (BVebo), measured in volts, for three base doping levels with and without subjecting the base 64 and emitter 75 to an oxidation step. These parameters are conventional performance parameters associated with a bipolar transistor. As shown in the below table, the inclusion of an oxidation step after formation of the base and emitter regions results in a bipolar transistor with increased current gain and increased breakdown voltage of the emitter-base junction. Increased current gain and increased breakdown voltage of the emitter-base junction are desirable in bipolar transistors and are indications of enhanced performance.

| Doping (x 10¹³/cm²⁾ | Oxidation Step ? | hFE | BVebo (V) |
|---|---|---|---|
| 6.0 | no | 135 | 4.9 |
| | yes | 145 | 5.6 |
| 6.5 | no | 122 | 4.8 |
| | yes | 138 | 5.4 |
| 7.0 | no | 108 | 4.7 |
| | yes | 126 | 5.4 |

FIGURE 16 illustrates reliability enhancements the invention. FIGURE 16 is a graph of emitter-base reverse bias voltage, measured in volts, versus time-to-fail, measured in seconds. Curve 210 represents data for transistors incorporating an oxidation step after formation of the base and emitter and curve 220 represents data for transistors not incorporating an oxidation step according to the invention. For a given reverse bias emitter-base voltage, the predicted transistor lifetime significantly increases for devices formed with the oxidation step. For example, for an emitter-base voltage of 3.0 volts, the predicted lifetime for a transistor formed by incorporating an oxidation step is approximately 8-9 x 10⁵ seconds. By comparison, a transistor formed without such an oxidation step has a predicted lifetime of less than 3 x 10⁴ seconds. Additionally, for a given desired lifetime, such as approximately 10 years (3.15 x 10⁸ seconds), the reverse-emitter bias voltage may be increased from approximately 2.5 volts to 2.8 volts. Thus devices having increased lifetime and devices that can operate at increased bias-voltages are provided.

The resulting semiconductor device 100 therefore includes a bipolar transistor with enhanced reliability and performance having an emitter 75, base 64, and collector 27, 39. The enhanced performance and reliability may be attributed to the reduction in the formation of hot carriers that may contribute to current gain degradation. Such reduction in the formation of hot carriers may be attributed to the incorporation of an oxidation step after formation of the base and emitter, which may have the effect of reducing the boron surface concentration cause by out-diffusion of boron during the oxidation process. The resulting bipolar transistor having an emitter 75, base 64, and collector 27, 39 therefore provides a bipolar device with increased useful life. In addition, due to the reduction in current gain degradation, such a bipolar device may operate at higher bias voltages, offering higher maximum bias voltage available to the designer, which is desirable. Additionally, greater bias voltages allow faster and more complicated circuits.

Although the invention has been particularly shown and described by the foregoing detailed description, it will be understood by those skilled in the art that various other changes in form and detail may be made without departing from the spirit and scope of the invention. For example, a bipolar transistor may be formed according to the teachings of the invention outside the context of a BiCMOS device.

## Claims

1. A method for fabricating a bipolar transistor comprising the steps of:
forming a collector region and an emitter region ;
forming a base region, the base region contacting the emitter region and the collector region; and
subjecting the base and emitter regions to an oxidation step after formation of the base and emitter regions.

2. The method of Claim 1, wherein the step of subjecting the base and emitter regions to an oxidation step comprises subjecting the base and emitter regions to a temperature of at least approximately 500° C in an environment comprising substantially oxygen.

3. The method of Claim 1 or Claim 2, wherein the step of subjecting the base and emitter regions to an oxidation step comprises subjecting the base and emitter regions to an environment comprising substantially oxygen for a period in the range of approximately 10 to 200 minutes.

4. The method of any of Claims 1 to 3, wherein the step of subjecting the base and emitter regions to an oxidation step comprises subjecting the base and emitter regions to a temperature of approximately 850° C in an environment comprising substantially oxygen for approximately 60 minutes.

5. The method of any of Claims 1 to 4 further comprising:
forming an insulating layer overlying at least a portion of the emitter.

6. The method of Claim 5, further comprising:
performing the step of oxidizing the emitter and base regions before forming said insulating layer over at least a portion of the emitter region.

7. The method of any of Claims 1 to 6, wherein the step of subjecting the base and emitter regions to an oxidation step comprises forming oxide on the base and emitter regions.

8. The method of any of Claims 1 to 7, wherein the step of forming the emitter region comprises forming an emitter region having a boron surface concentration, and wherein the step of subjecting the base and emitter regions to an oxidation step comprises reducing the boron surface concentration in the emitter region.

9. The method of any of Claim 1 wherein the step of subjecting the base and emitter regions to an oxidation step comprises:
placing the base and emitter regions in a first nitrogen environment;
ramping the temperature of the first nitrogen environment from a first temperature to a second temperature;
stabilizing the temperature at the second temperature;
placing the base and emitter regions in an oxygen environment;
annealing the base and emitter regions in a second nitrogen environment; and
reducing the temperature of the second nitrogen environment.

10. The method of Claim 9, wherein the step of ramping the temperature comprises ramping the temperature from a first temperature of approximately 775°C to a second temperature of approximately 850°C.

11. The method of Claim 9 or Claim 10, wherein the step of stabilizing the temperature comprises stabilizing the temperature for a period of approximately 10 minutes.

12. The method of any of Claims 9 to 11, wherein the step of placing the base and emitter regions in an oxygen environemnt comprises placing the base and emitter regions in an oxygen environment for a period of approximately 60 minutes.

13. The method of any of Claims 9 to 12, wherein the step of annealing comprises annealing the base and emitter regions for a period of approximately 20 minutes.

14. The method of any of Claims 9 to 13, wherein the step or reducing the temperature comprises reducing the temperature from a second temperature of approximately 850°C to a first temperature of approximately 775°C.

15. A method for fabricating an integrated circuit, comprising the steps of:
forming a first transistor on a surface of a substrate;
forming a bipolar transistor on the surface; and wherein the step of forming a bipolar transistor comprises the steps of:
forming a collector region and an emitter region;
forming a base region contacting the emitter region and the collector region; and
subjecting the base and emitter regions to an oxidation step.

16. The method of Claim 15, wherein the step of fabricating an integrated circuit comprises forming a BICMOS integrated circuit.

17. The method of Claim 15 or Claim 16, wherein the step of forming the first transistor comprises forming a CMOS transistor.

18. The method of any of Claims 15 to 17, wherein the step of forming the first transistor comprises depositing an implant in a source and a drain associated with a field effect transistor associated with the first transistor.

19. The method of any of Claim 18, wherein the step of subjecting the base and emitter regions to an oxidation step comprises subjecting the base and emitter regions to an oxidation step before the step of depositing an implant in the source and drain regions associated with the field effect transistor.

20. The method of any of Claims 15 to 19, wherein the step of subjecting the base and emitter regions to an oxidation step comprises subjecting the base and emitter regions to a temperature of at least approximately 500°C in an environment substantially comprising oxygen..

21. The method of any of Claims 15 to 20, wherein the step of subjecting the base and emitter regions to an oxidation step comprises subjecting the base and emitter regions to an environment substantially comprising oxygen for a period in the range of approximately 10 to 200 minutes.

22. The method of any of Claims 15 to 21, wherein the step of forming the emitter region comprises forming an emitter region having a boron surface concentration, and wherein the step of subjecting the base and emitter regions to an oxidation step comprises reducing the boron surface concentration in the emitter region.

23. The method of any of Claims 15 to 22 further comprising:
forming an insulating layer overlying at least a portion of the emitter region.

24. The method of Claim 23, wherein the step of subjecting the base and emitter regions to an oxidation step comprises subjecting the emitter and base regions to an oxidation step before forming an insulating layer over at least a portion of the emitter region.

25. A method for fabricating an integrated circuit comprising the steps of:
forming a collector region of a buried collector bipolar transistor in a surface of a substrate;
forming a base region overlying at least a portion of the collector region; the emitter region having a second conductivity type;
forming a emitter region overlying a portion of the base region;
forming an emitter contact contacting with the emitter region;
forming an insulating layer overlying a portion of the emitter region and in contact with the emitter contact; and
subjecting the base and emitter regions to an oxidation step before forming the insulating layer and after formation of both the base and emitter regions.

26. The method of Claim 25, wherein the step of subjecting the base and emitter regions to an oxidation step comprises subjecting the base and emitter regions to a temperature of at least approximately 500° C in an environment substantially comprising oxygen..

27. The method of Claim 25 or Claim 26, wherein the step of subjecting the base and emitter regions comprises subjecting the base and emitter regions to an environment substantially comprising oxygen for a period in the range of approximately 10 to 200 minutes.

28. The method of any of Claims 25 to 27, wherein the step of subjecting the base and emitter regions to an oxidation step comprises subjecting the base and emitter regions to an environment substantially comprising oxygen at approximately 850° C for approximately 60 minutes.

29. The method of any of Claims 25 to 28, wherein step of subjecting the base and emitter regions to an oxidation step comprises forming oxide over the base and emitter regions.

30. The method of any of Claims 15 to 29, wherein the step of forming the emitter region comprises forming an emitter region having a boron surface concentration, and wherein the step of subjecting the base and emitter regions to an oxidation step comprises reducing the boron surface concentration in the emitter region.
